# EUROPEAN PATENT SPECIFICATION

(11) **EP 3 491 891 B1**
(45) Date of publication and mention of the grant of the patent: **04.06.2025**
(21) Application number: 17834906.4
(22) Date of filing: 26.05.2017
(51) Int. Cl.: H05B 45/10, H05B 45/38

(54) **DIMMING LED CIRCUIT AUGMENTING DC/DC CONTROLLER INTEGRATED CIRCUIT**
INTEGRIERTE SCHALTUNG MIT GLEICHSTROMSTEUERGERÄT FÜR DIMMBARE LED-SCHALTUNGSVERSTÄRKUNG
CIRCUIT DE GRADATION DE DEL AUGMENTANT LE CIRCUIT INTÉGRÉ DE CONTRÔLEUR CC/CC

(30) Priority: 28.07.2016 US 201662367984 P; 29.09.2016 EP 16191428
(43) Date of publication of application: 05.06.2019
(73) Proprietor: Lumileds LLC, San Jose, CA 95131 (US)
(72) Inventor: SONG, Zhihua, San Jose, CA 95131 (US); SOER, Wouter, San Jose, CA 95131 (US); BONNE, Ron, San Jose, CA 95131 (US); QIU, Yifeng, San Jose, CA 95131 (US)
(74) Representative: Beckord & Niedlich Patentanwälte PartG mbB
(86) International application number: PCT/US2017/034662
(87) International publication number: WO 2018/022181

(56) References cited:
- WO-A1-2013/016355
- JP-A- 2015 084 616
- JP-A- 2016 119 830
- US-A1- 2012 188 487
- US-A1- 2014 009 077
- US-A1- 2014 252 974
- US-A1- 2015 145 439
- US-A1- 2015 334 800
- US-B2- 8 564 370
- US-B2- 9 232 606
- ANONYMOUS: "L6562 TRANSITION-MODE PFC CONTROLLER", 1 November 2005 (2005-11-01), pages 1 - 16, XP002596716, Retrieved from the Internet <URL:http://www.st.com/stonline/products/literature/ds/9461.pdf> [retrieved on 20100816]

## Description

### BACKGROUND

The ability to dim light emitting diodes (LEDs) is an important feature in many of today's solid state lighting applications. Unlike conventional incandescent bulbs, which may be dimmed using pulses of voltage, an LED is a very different load. First, the LED needs to be driven by a current source rather than a voltage source. While this is not difficult in itself, it does require a different supply design. Second, and much more difficult, the LED is a diode-like, highly non-linear load, even more complicated than just a simple reactive (capacitive or inductive) load. One way to way to dim the LED is to reduce its drive or current.

US 2015/334800 A1 and US 2014/252974 A1 both disclose an LED module with a single stage AC input flyback converter but do not disclose a resistor connected to a cathode of an LED array or a differential amplifier coupled to a variable dimming voltage.

US 9 232 606 B2 and JP 2016 119830 A disclose an LED module with a single stage AC input converter, which is not a boost converter, but do not disclose a differential amplifier coupled to a variable dimming voltage and to a voltage across a resistor connected to a cathode of an LED array.

US 2014/009077 A1 discloses an LED module with a two stage AC input converter and a differential amplifier coupled to a variable dimming voltage to a voltage across a resistor connected to a cathode of an LED array but does not disclose a single stage AC input boost converter or a controller having an error amplifier coupled to an output voltage of the differential amplifier.

US 2012/188487 A1 discloses an LED module with a single stage DC input boost converter for driving an LED array and a differential amplifier coupled to a variable dimming voltage but does not disclose a single stage AC input boost converter or a differential amplifier is coupled to the voltage across a resistor connected to a cathode of an LED array said voltage being regulated to the variable dimming voltage.

JP 2015 084616 A discloses an LED module with a single stage AC input SEPIC converter with a signal amplifier for amplifying a current sense voltage which is lower than an on-chip fixed reference voltage but does not disclose a differential amplifier coupled to a variable dimming voltage.

### SUMMARY

The invention is set out in the appended set of claims.

Embodiments include systems, methods, and apparatuses for driving and dimming one or more light emitting diodes (LEDs). In an embodiment, the LED module comprises a resistor connected to a cathode end of one or more LEDs and a ground. A voltage across the resistor is proportional to a current through the one or more LEDs. The claimed LED module includes a differential amplifier. A first input of the differential amplifier is coupled to the voltage across the resistor and a second input of the differential amplifier is coupled to a variable dimming voltage controlled by a user. The claimed LED module includes a controller for regulating an output voltage supplied to an anode end of the one or more LEDs. The controller includes an error amplifier having a first input coupled to a fixed internal reference voltage and a second input coupled to an output voltage of the differential amplifier. The claimed LED module includes a switching transistor coupled to the controller.

The controller turns the switching transistor on and off based on an output of the differential amplifier to vary the output voltage and the current through the one or more LEDs to adjust the brightness of the one or more LEDs.

### BRIEF DESCRIPTION OF THE DRAWINGS

A more detailed understanding may be had from the following description, given by way of example in conjunction with the accompanying drawings wherein:
FIG. 1 is a circuit diagram of a prior art 2-stage AC input light emitting diode (LED) driver;
FIG. 2 is a block diagram illustrating a controller integrated circuit (IC) as used in the prior art;
Figures 3 - 7 illustrate the invention, whereby:

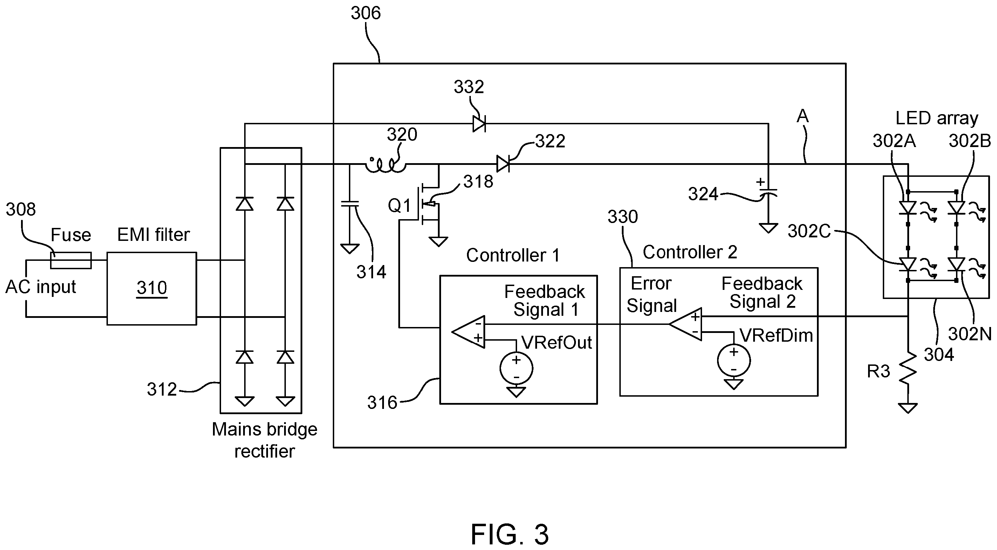

   FIG. 3 is a circuit diagram of a single stage AC input boost converter to directly drive and dim LEDs;

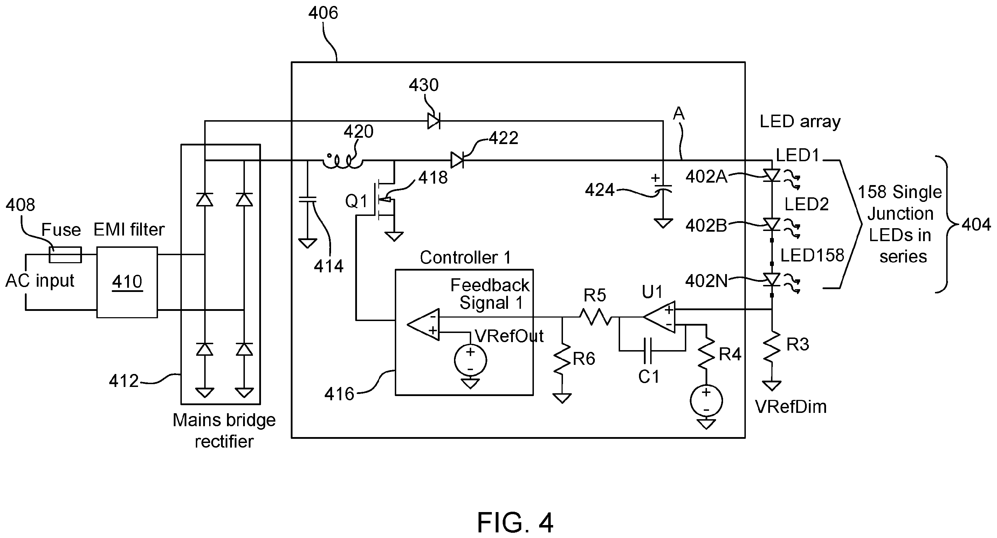

   FIG. 4 is a circuit diagram of a single stage AC input boost converter that uses a universal 120-277 V AC input voltage to directly drive and dim one or more LEDs;

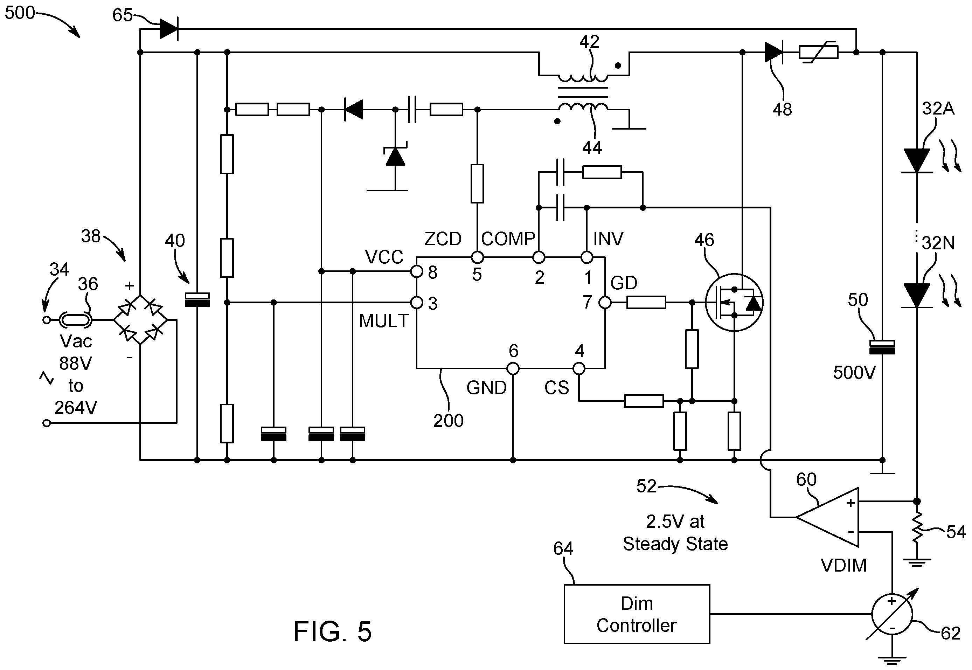

   FIG. 5 is a circuit diagram of a single stage AC input boost converter configured with a controller and a first dimming circuit;

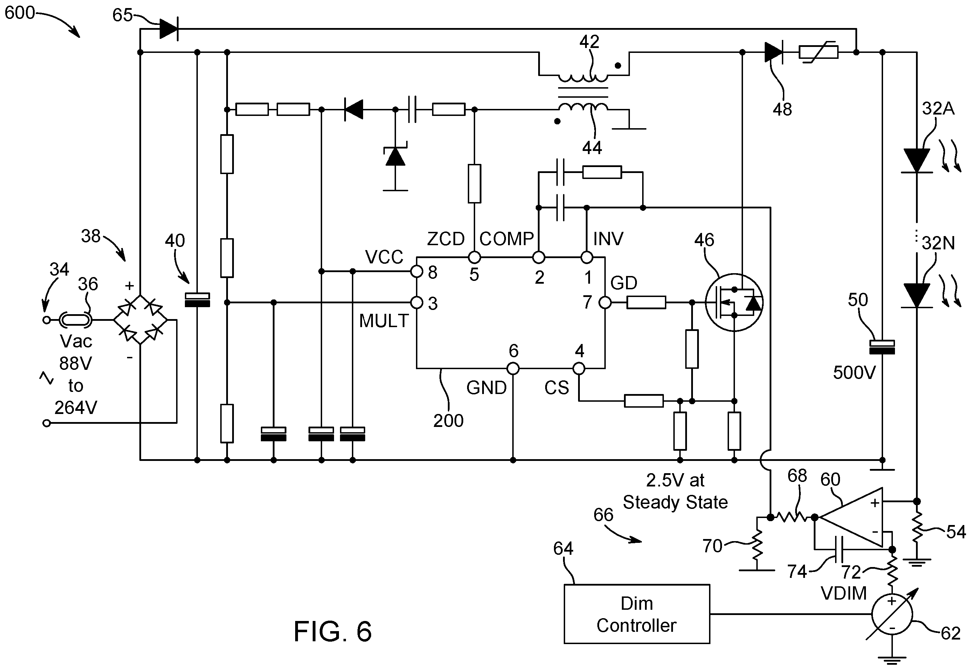

   FIG. 6 is a circuit diagram of a single stage AC input boost converter configured with a controller and a second dimming circuit; and

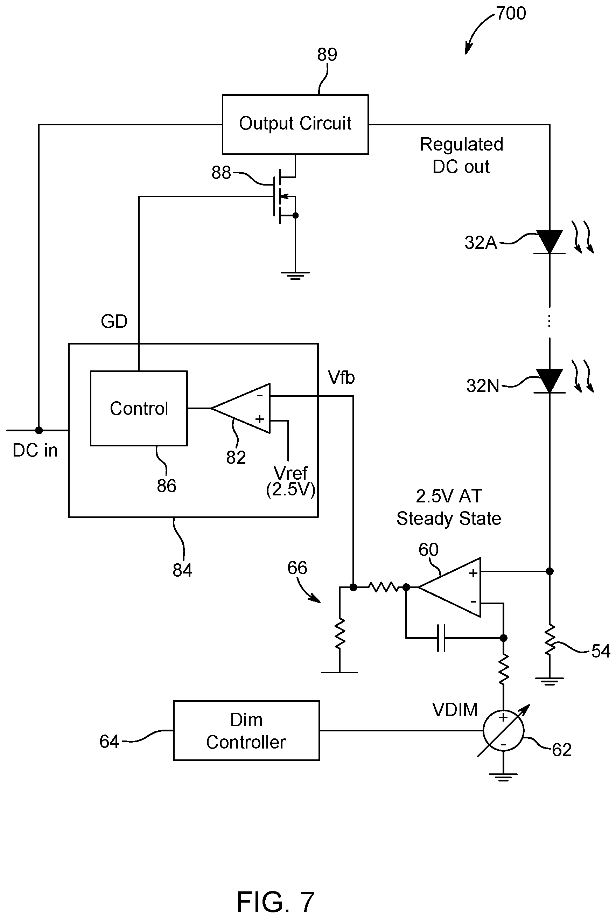

   FIG. 7 is a circuit diagram illustrating a generic converter circuit with a dimming function.

### DETAILED DESCRIPTION

In the following description, numerous specific details are set forth, such as particular structures, components, materials, dimensions, processing steps, and techniques, in order to provide a thorough understanding of the present embodiments. However, it will be appreciated by one of ordinary skill of the art that the embodiments may be practiced without these specific details. In other instances, well-known structures or processing steps have not been described in detail in order to avoid obscuring the embodiments. It will be understood that when an element as a layer, region, or substrate is referred to as being "on" or "over" another element, it can be directly on the other element or intervening elements may also be present. In contrast, when an element is referred to as being "directly on" or "directly" over another element, there are no intervening elements present. It will also be understood that when an element is referred to as being "beneath," "below," or "under" another element, it can be directly beneath or under the other element, or intervening elements may be present. In contrast, when an element is referred to as being "directly beneath" or "directly under" another element, there are no intervening elements present.

In the interest of not obscuring the presentation of embodiments in the following detailed description, some processing steps or operations that are known in the art may have been combined together for presentation and for illustration purposes and in some instances may have not been described in detail. In other instances, some processing steps or operations that are known in the art may not be described at all. It should be understood that the following description is rather focused on the distinctive features or elements of various embodiments described herein.

In some light emitting diode (LED) lighting applications, it may be desirable to have a dimming capability, where the user is able to control the brightness of the LEDs. Conventional LED drivers may include a dimming function, but these drivers may not be appropriate for a particular application and/or may not have certain desired features.

For example, an LED module that uses a rectified AC mains voltage as the power source may be connected to about 150 LEDs in series, which may result in a voltage drop of over 450 V. A boost converter may be used to step up the rectified voltage to over 450 V in conjunction with a self-oscillating switching circuit (i.e., no oscillator used). Accordingly, a general purpose (non-LED) off-the-shelf boost converter controller IC using self-oscillation may be the preferred choice of controller to use in the boost converter for economic reasons. However, because an internal reference voltage reference applied to an internal error amplifier may be a fixed reference voltage, a general purpose boost converter controller IC may not have a dimming capability. Accordingly, it may be desirable to design a LED driver using a conventional controller that also has a dimming function. This object is achieved by the claimed LED module and the claimed method of operating an LED module.

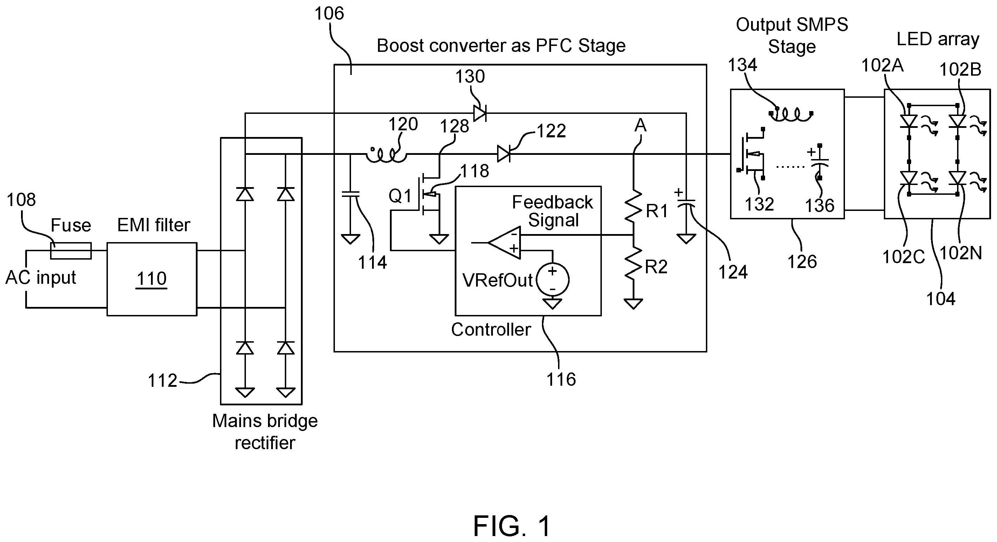

Referring now to FIG. 1, a circuit diagram of a prior art 2-stage AC input LED driver is shown. A boost converter 106 is used as a power factor correction (PFC) in a 2-stage switching mode power supply (SMPS) to achieve a high quality input current to drive one or more (e.g., 158) LEDs 102A-102N in a LED array 104. Each of the one or more LEDs 102A-102N may be a blue-emitting GaN-based LED and may drop about 3 volts. Therefore, the boost converter 106 may boost a rectified AC mains voltage to, for example, 474 V. A phosphor may convert the blue LED light to white light for general illumination. The boost converter 106 may also maintain a stable output voltage irrespective of variation of input voltage and output load.

The AC mains voltage may be applied, via a fuse 108, to an EMI filter 110. A full diode bridge of a mains bridge rectifier 112 may rectify the AC voltage and an input capacitor 114 may at least partially filter the rectified AC voltage. A controller 116 may turn on a switching transistor 118 and a right end of an inductor 120 may be pulled to ground for charging the inductor 120. The controller 116 may be a conventional transition-mode PFC controller. The controller 116 may be an integrated circuit (IC) configured to control PFC pre-regulators by using a transition mode technique.

The controller 116 may be used for a boost mode, a buck mode, or a buck-boost mode converter.

At a particular time in the switching cycle to generate a target current through the one or more LEDs 102A-102N, the switching transistor 118 may be turned off. This may result in the voltage at the right end of the inductor 120 rising to forward bias a diode 122. This may recharge an output capacitor 124, which may smooth the waveform and essentially supply a DC voltage to an output at a regulated current to an output SMPS stage 126.

The switching transistor 118 may switch on and off at a relatively high frequency, such as approximately 10 kHz to approximately 1 MHz. The switching transistor 118 may couple a right end of an inductor 120 to either a ground or a positive voltage at the high frequency to generate the boosted output voltage. The switching transistor 118 may be a metal-oxide-semiconductor field-effect transistor (MOSFET) or a bipolar transistor that carries a steep slope voltage waveform, which may be a square wave voltage, at the switching frequency.

It should be noted that the term "square wave," as used herein, does not require the waveform to have rectangular pulses. Neither does it require the waveform to have a duty cycle of 50% (i.e., having equal durations of high and low levels). In some applications, non-instantaneous switching and parasitic effects may result in non-rectangular waveforms. Accordingly, the term "square wave" means a switched voltage that swings between a high level and low level as a result of a switching transistor being turned on and off at times to achieve a target output voltage or current.

Accordingly, the high frequency square wave voltage may be generated with a relatively high voltage (e.g., up to 500 V), and a relatively large average current (e.g., up to 1 Amp). The output capacitor 124 may be used to somewhat filter the ripple to supply a regulated DC current. In one example, the square wave voltage may rapidly transition between ground and about 500 V. A drain node 128 of the switching transistor 118 may carry the square wave voltage. Any high frequency ripple in the current supplied may be acceptable since any high frequency ripple may not be perceived, as long as the peak current stays within the current rating of the one or more LEDs 102A-102N. A separate diode-coupled path containing a diode 130 may exist between the mains bridge rectifier 112 and the output capacitor 124. The separate diode-coupled path may provide for a fast partial charge up upon start-up.

The output SMPS stage 126 may include at least a switching transistor 132, a magnetic component 134 and a capacitor 136. The output SMPS state 126 may convert the output voltage of the boost converter 106 into a current to drive the LED array 104.

As shown in FIG. 1, voltage feedback in the 2-stage AC input LED driver may be a negative feedback system. A divided resistor, made up of a first resistor R1 and a second resistor R2 may be connected as a feedback signal to sense the boost converter output voltage at node A. The booster converter output voltage may be compared to a fixed reference voltage V_{RefOut} in the controller 116. By controlling the gate voltage of the switching transistor 118, the voltage input into the controller 116 may be regulated to be essentially same as V_{RefOut}. This may result in A-node voltage that is regulated to the required level.

The 2-stage AC input LED driver may have good performance characteristics, but it may suffer from disadvantages of relatively high cost, low efficiency, large form factor, and increased design complexity.

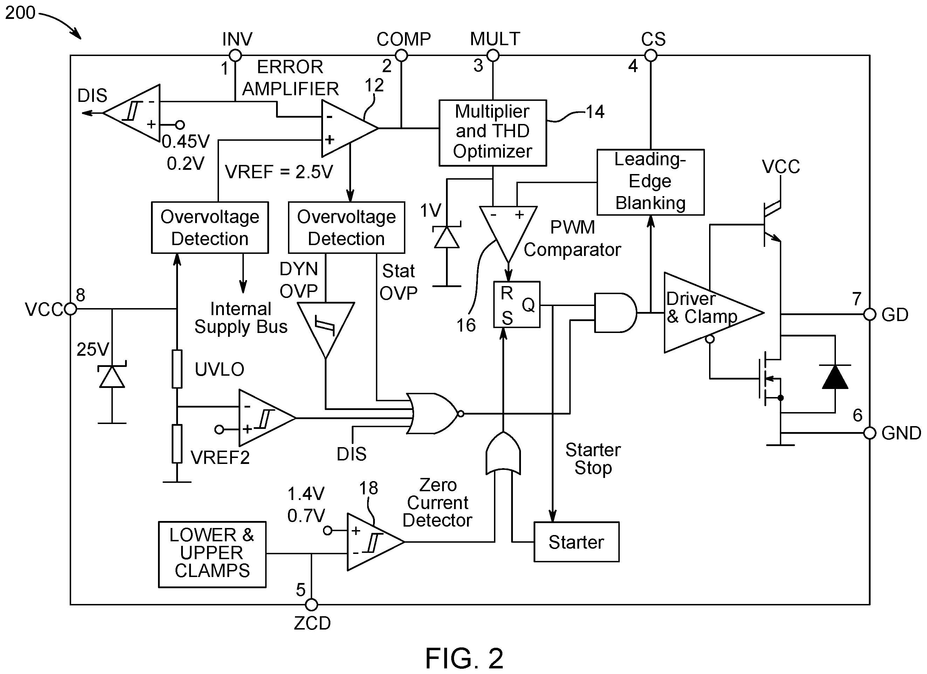

Referring now to FIG. 2, a block diagram illustrating a controller 200 is shown. The controller 200 may be a conventional PFC controller built on an integrated circuit (IC) and may be used as the controller 116 as shown in FIG. 1. The controller 200 may include one or more pins connecting it to the LED module.

An inverting input (INV) pin 1 may invert an input of an error amplifier 12. Information on an output voltage of a PFC pre-regulator may be fed into the INV pin 1 through a resistor divider.

A compensation (COMP) pin 2 is connected to an output of the error amplifier 12. A compensation network (not shown) may be placed between this pin and the INV pin 1 to achieve stability of a voltage control loop and ensure a high power factor and low total harmonic distortion (THD).

A multiplier (MULT) pin 3 may be a main input to a multiplier 14. The MULT pin 3 may be connected to the mains voltage via a resistor divider (not shown) and may provide a sinusoidal reference to a current loop.

A current sense (CS) pin 4 may be an input to a pulse width modulator (PWM) comparator 16. Current flowing through the switching transistor 118 may be sensed through a resistor. The resulting voltage may be applied to this pin and compared with an internal sinusoidal-shaped reference, which may be generated by the multiplier 14. This may be used to determine the turn-off of an external power transistor.

A zero crossing detector (ZCD) pin 5 may boost a demagnetizing sensing input of the inductor 120 for transition-mode operation. A negative-going edge may trigger the turn-on of the external power transistor.

A ground (GND) pin 6 may act as a current return for the signal part of the controller 200 and a gate driver.

A gate driver (GD) pin 7 may be a gate driver output. A totem pole output stage may be able to drive the external power transistor with a peak current of approximately 600 mA source and 800 mA sink. The high-level voltage of this the GD pin 7 may be capped at approximately 12 V to avoid excessive gate voltages in case it is supplied with a high supply voltage (V_{cc}).

A V_{cc} pin 8 may be the supply voltage of the signal part of the controller 200 and the gate driver. The supply voltage upper limit may be extended to 22 V min. to provide additional headroom for supply voltage changes.

The GD pin 7 may be connected to the gate of the external power transistor, which may be the switching transistor 118 as shown in FIG. 1. The external power transistor may be connected to a suitable output circuit for generating a regulated voltage or current. The current through the external power transistor (and an inductor) may be sensed and a current feedback signal may be applied to the CS pin 4.

A divided output voltage may be fed back into the error amplifier 12 via the INV pin 1. The divided output voltage may be the R2 voltage as described above with reference to FIG. 1. A non-inverting input of the error amplifier 12 may be coupled to an internal reference voltage V_{ref}, which may be fixed at 2.5 volts. The multiplier 14 may be used to modulate the output of the error amplifier 12, which may be compensated by an external capacitor connected to the COMP pin 2, by a sinusoidal rectified AC mains voltage (e.g., 120 Hz). The sinusoidal rectified AC mains voltage may be used as the input voltage for the PFC stage 106 as shown in FIG. 1. The PWM comparator 16 may compare the current signal at the high switching frequency, such as 14kHz, to the output of the multiplier 14 to reset (i.e., turn off) the external power transistor during each switching cycle to achieve regulation.

The voltage and current feedback loops may cause the two inputs into the error amplifier 12 to match. The external power transistor may be turned back on when a zero current detector 18 detects that the current through the inductor 120 in FIG. 1 is approximately zero to reduce switching losses.

As with other conventional controllers, the error amplifier 12 is internal to the IC and the internal reference voltage is fixed. Accordingly, the controller 200 may not be able to drive series-connected LEDs using a dimming controller, since the error amplifier 12 compares the divided output voltage to a fixed 2.5 volt reference. An LED driver that uses this control but has a dimming function may be desirable.

Embodiments of the invention are explained in the following with the aid of Figures 3 - 7.

Referring now to FIG. 3, a circuit diagram of a single stage AC input boost converter to directly drive and dim LEDs is shown. The single stage circuit uses a boost converter as both the PFC stage and output stage to drive the LED array. The LED array is directly connected to the boost output. Unlike the 2-stage AC input LED driver shown in FIG. 1, no additional output SMPS stage (as shown as output SMPS stage 126) is needed. As described below, the average output voltage control of the boost converter is changed to average output current control to control the LED current for dimming purposes.

A single stage boost converter 306 is used as the PFC and the output stage to achieve a high quality input current to drive one or more (e.g., 158) LEDs 302A-302N in series in a LED array 304. Each of the one or more LEDs 302A-302N may be a blue-emitting GaN-based LED and may drop about 3 volts. Therefore, the boost converter 306 may boost a rectified AC mains voltage to at least 474 V to drive the one or more LEDs 302A-302N. A phosphor may convert the blue LED light to white light for general illumination. The boost converter 306 may also maintain a stable output voltage irrespective of variation of input voltage and output load.

The AC mains voltage is applied, via a fuse 308, to an EMI filter 310. A full diode bridge of a mains bridge rectifier 312 rectifies the AC voltage and an input capacitor 314 at least partially filters the rectified AC voltage. A first controller 316 and a second controller 330 may operate together to turn on a switching transistor 318 and a right end of an inductor 320 is pulled to ground for charging the inductor 320. The first controller 316 is similar to the controller 116 described above with reference to FIG. 1.

At a particular time in the switching cycle to generate a target current through the one or more LEDs 302A-302N, the switching transistor 318 is turned off. This results in the voltage at the right end of the inductor 320 rising to forward bias a diode 322. This recharges an output capacitor 324, which smooths the waveform and essentially supply a DC voltage at a regulated current to the one or more LEDs 302A-302N.

The switching transistor 318 may switch on and off at a relatively high frequency, such as approximately 10 kHz to approximately 1 MHz. The switching transistor 318 couples a right end of an inductor 320 to either a ground or a positive voltage at the high frequency to generate the boosted or output voltage. The switching transistor 318 may be a metal-oxide-semiconductor field-effect transistor (MOSFET) or a bipolar transistor that carries a steep slope voltage waveform, which may be a square wave voltage, at the switching frequency.

There is a separate diode-coupled path containing a diode 332 between the mains bridge rectifier 312 and the output capacitor 324. The separate diode-coupled path provides for a fast partial charge up upon start-up. Upon start-up, the output capacitor 324 voltage may be less than the rectified mains voltage. The forward biasing of the diode 332 quickly charges the output capacitor 324 to the rectified mains voltage. Thereafter, the voltage across the output capacitor 324 is increased to the regulated level and the diode 332 becomes reverse biased.

Voltage feedback in the single stage boost converter 306 is based on an output current of the LED array 304. As shown in FIG. 3, the divided resistor made up of R1 and R2 has been changed to a resistor R3, which is connected to the LED array 304 and senses the LED array current. The R3 voltage is used as feedback signal of the second controller 330. The R3 voltage is compared to a variable reference voltage V_{RefDim}. The V_{RefDim} may vary with a dimming command, which may be input through any conventional means, such as a dial, knob, or digital input. The higher the value of V_{RefDim}, the higher the current required from the boost converter 306.

The second controller 330 outputs an error signal as an input to the first controller 316. The error signal represents the difference between the R3 voltage and the V_{RefDim}. The first controller 316 uses the error signal as a feedback signal to be compared to VRefOut, which is a fixed reference voltage. By controlling the gate voltage of the switching transistor 318, the R3 voltage is regulated to be essentially the same as V_{RefDim}. This regulates the LED current to a required level. As V_{RefDim} varies with a dimming command, the LED current will change, and the LED array 304 is dimmed as required.

Because of the high output voltage of the boost converter 306, the LED array 304 may have a high total forward voltage. This may help improve circuit efficiency due to lower current and circuit losses. Depending on the application requirements, high-voltage (multi-junction) LEDs may be used in the LED array 304 to reduce the number of LEDs needed to achieve the high total forward voltage. The single stage AC input boost converter may be used in different configurations to directly drive and dim LEDs.

Referring now to FIG. 4, a circuit diagram of a single stage AC input boost converter 406 that uses a universal 120-277 V AC input voltage to directly drive and dim one or more LEDs 402A-402N is shown.

A single stage boost converter 406 is used as the PFC and the output stage to achieve a high quality input current as well as to drive one or more (e.g., 158) LEDs 402A-402N. The one or more LEDs 402A-402N may be single junction LEDs connected in series. Alternatively, the one or more LEDs 402A-402N may be multi-junction LEDs connected in series.

Each of the one or more LEDs 402A-402N may be a blue-emitting GaN-based LED. Each single junction LED may drop about 3 volts, thus 158 LEDs in series may drop 474 V. Therefore, the boost converter 406 may boost a rectified AC mains voltage to approximately 474 V to drive the one or more LEDs 402A-402N. A phosphor may convert the blue LED light to white light for general illumination. The boost converter 406 may also maintain a stable output voltage irrespective of variation of input voltage and output load.

The AC mains voltage may be applied, via a fuse 408, to an EMI filter 410. A full diode bridge of a mains bridge rectifier 412 rectifies the AC voltage and an input capacitor 414 at least partially filters the rectified AC voltage. A controller 416 turn on a switching transistor 418 and a right end of an inductor 420 is pulled to ground for charging the inductor 420. The controller 416 is similar to the controller 116 described above with reference to FIG. 1.

At a particular time in the switching cycle to generate a target current through the one or more LEDs 402A-402N, the switching transistor 418 may be turned off. This results in the voltage at the right end of the inductor 420 rising to forward bias a diode 422. This charges an output capacitor 424, which smooths the waveform and essentially supplies a DC voltage at a regulated current to the one or more LEDs 402A-402N.

The switching transistor 418 may switch on and off at a relatively high frequency, such as approximately 10 kHz to approximately 1 MHz. The switching transistor 418 couples a right end of an inductor 420 to either a ground or a positive voltage at the high frequency to generate the boosted or decreased output voltage. The switching transistor 418 may be a metal-oxide-semiconductor field-effect transistor (MOSFET) or a bipolar transistor that carries a steep slope voltage waveform, which may be a square wave voltage, at the switching frequency.

There is a separate diode-coupled path containing a diode 430 between the mains bridge rectifier 412 and the output capacitor 424. The separate diode-coupled path provides for a fast partial charge up upon start-up. Upon start-up, the output capacitor 424 voltage may be less than the rectified mains voltage. The forward biasing of the diode 430 quickly charges the output capacitor 424 to the rectified mains voltage. Thereafter, the voltage across the output capacitor 424 increases to the regulated level and the diode 430 becomes reverse biased.

Voltage feedback in the single stage boost converter 406 is based on an output current of the LED array 404. An operational amplifier U1 is used to amplify a difference between R3 voltage representing the current through the one or more LEDs 402A-402N and a VRefDim representing a dimming command or level. The output of the operational amplifier U1 is scaled down via a resistor divider R5/R6 and then connected as the feedback signal of the controller 416. A capacitor C1 is used as frequency compensation for the operational amplifier U1.

Referring now to FIG. 5, a circuit diagram of a single stage AC input boost converter 500 configured with the controller 200 and a first dimming circuit 52 is shown. The circuit diagram illustrates aspects of a typical application circuit that produces a driving current based on an input of a wide-range mains voltage. It should be noted that well-known structures, including one or more resistors, diodes, and capacitors, and processing steps have not been described in detail in order to avoid obscuring the embodiments described herein.

The single stage AC input boost converter 500 directly drive and dim a series string of LEDs 32A-32N. The series string of LEDs 32A-32N may be 158 LEDs in series, each dropping around 3 volts. The single stage AC input boost converter 500 may generate, for example, 474 V. Multi-junction LEDs may instead be used. As shown in FIG. 2, the controller 200 may be an IC having an on-chip error amplifier and an internal fixed voltage reference coupled to an input of the error amplifier. The controller 200 is not typically used for supplying a dimmable control for LEDs.

Voltage feedback in the single stage AC input boost converter 500 may be provided by a differential amplifier 60 and a dimming controller 64. The series string of LEDs 32A-32N may be driven by the regulated current output of the single stage AC input boost converter 500.

There is a separate diode-coupled path containing a diode 65 between a rectified AC mains voltage, provided by a full diode bridge 38, and an output capacitor 50. The separate diode-coupled path provides for a fast partial charge up upon start-up. Upon start-up, the output capacitor 50 voltage may be less than the rectified mains voltage. The forward biasing of the diode 65 quickly charges the output capacitor 50 to the rectified mains voltage.

Thereafter, the voltage across the output capacitor 50 increases to the regulated level and the diode 65 becomes reverse biased.

An input power supply may be an AC mains voltage 34. A fuse 36 may couple the AC mains voltage 34 to the full diode bridge 38 to rectify the voltage. The rectified AC voltage is smoothed by an input capacitor 40.

A DC voltage V_{cc} is supplied to a package pin, such as a DIP-8 or SO-8 terminal at terminal 8 of the controller 200 for powering the chip. The controller 200 may include a voltage regulator to power the internal circuitry.

After leaving the full diode bridge 38, the rectified voltage is applied to a primary winding 42 (i.e., inductor) of a transformer. The voltage passing through a secondary winding 44 of the transformer is detected for a zero current crossing in the primary winding 42. This indicates that the primary winding 42 has depleted its stored energy. The detected voltage signal is applied to a zero crossing detector (ZCD) pin 5 of the controller.

The controller 200 turns on a power switching transistor 46 when the zero crossing current is detected. The turning on of the switching transistor 46 couples the right end of the primary winding 42 to a ground in order to recharge the primary winding 42. The switching transistor 46 is turned off when a voltage signal proportional to the instantaneous switching transistor 46 current, applied to the current sense (CS) pin 4 of the controller 200, crosses a threshold set by the output of a multiplier 14 internal to the controller 200. This turn-on and turn-off cycle repeats. The duty cycle (i.e., on time/cycle time) may be what is required to keep an input of an error amplifier 12, which may be internal to the controller 200, at 2.5 V.

When the switching transistor 46 turns off, the right end of the primary winding 42 rises to forward bias a diode 48 to charge the output capacitor 50 to supply a DC output voltage to the load. The switching frequency of the switching transistor 46 is determined by the self-oscillation. The switching frequency may be over 10 kHz.

Instead of a resistor divider (shown in FIG. 1) connected across the DC voltage output of the output capacitor 50, where the selection of the resistors generates exactly 2.5 volts at the target output voltage, feedback voltage may be obtained from the output of the differential amplifier 60. The feedback voltage may be applied to the INV pin 1 of the controller. From the INV pin 1, the feedback voltage may be sent to the inverting input port of the error amplifier 12.

An anode end of the series string of LEDs 32A-32N is connected to the top terminal of the output capacitor 50. A low value sense resistor 54 is connected between the cathode end of the series string of LEDs 32A-32N and a ground. The voltage across the low value sense resistor 54 is proportional to the current through the series string of LEDs 32A-32N, which is related to the brightness level. The top node of the low value sense resistor 54 is coupled to a non-inverting input of the differential amplifier 60, which amplifies the voltage difference between the voltage from the low value sense resistor 54 and a reference dimming voltage at its inputs. The differential amplifier 60 may also be connected as an operational amplifier (not shown).

The inverting input of the differential amplifier 60 is connected to a variable voltage source dim controller 62, which outputs a dimming voltage V_{dim}. The level of V_{dim} is controlled by a user controlled input of the dimming controller 64.

In order to achieve a steady state regulation of the current supplied to the series string of LEDs 32A-32N, the output of the differential amplifier 60 may be 2.5 volts. This ensures that the inputs into the error amplifier 12 match. Due to the high gain of the differential amplifier 60, the V_{dim} signal and the voltage across the low value sense resistor 54 may be approximately matched when a target current is generated and supplied to the series string of LEDs 32A-32N. In this way, the level of V_{dim}, supplied by the dim controller 64 controls the brightness of the series string of LEDs 32A-32N while using the conventional controller 200 in the single stage AC input boost converter 500.

Referring now to FIG. 6, a circuit diagram of a single stage AC input boost converter 600 configured with the controller 200 and a second dimming circuit 66 is shown. The circuit diagram illustrates aspects of a typical application circuit that produces a driving current based on an input of a wide-range mains voltage. It should be noted that well-known structures, including one or more resistors, diodes, and capacitors, and processing steps have not been described in detail in order to avoid obscuring the embodiments described herein.

The single stage AC input boost converter 600 directly drives and dims the series string of LEDs 32A-32N. The single stage AC input boost converter 600 is similar to the single stage AC input boost converter described above with reference to FIG. 5. However, the second dimming circuit 66 includes a resistor divider, including resistor 68 and resistor 70, to match the voltage range of the output of the differential amplifier 60 and the INV pin 1 of the controller 200. A resistor 72 and a capacitor 74 provide frequency compensation for a more stable operation of the negative feedback system to avoid oscillation.

Referring now to FIG. 7, a circuit diagram illustrating a generic converter circuit 700 with a dimming function is shown. The generic converter circuit 700 includes an IC 84 with an error amplifier 82 and a fixed voltage reference source generating Vref, which is augmented with a dimming capability. The generic converter circuit 700 includes the second dimming circuit 66. An on-chip controller 86 controls the duty cycle of a switching transistor 88 to achieve a regulated current through the series string of LEDs 32A-32N. The controller 86 is similar to the controller 200 described above with reference to FIG. 2. The controller 86 uses at least the feedback from a differential amplifier 60 and an error amplifier 82 to keep the inputs into the error amplifier 82 equal (e.g., 2.5 volts). The controller 86 may use self-oscillation or an on-chip oscillator to control the switching frequency of a switching transistor. An output circuit 89 may contain a conventional inductor/capacitor/diode circuit commonly used in a boost configuration. It should be noted that other configurations may be used.

Although an input port of the differential amplifier 60 is shown directly coupled to the current sense resistor 54, there may be other components that create a proportional signal applied to the amplifier 60. The switching transistor may be internal or external to the IC 84.

Although features and elements are described above in particular combinations, one of ordinary skill in the art will appreciate that each feature or element can be used alone or in any combination with the other features and elements.

## Claims

1. An LED module comprising:
a resistor (R3, 54) connected to a cathode end of an LED array (304, 404) of the LED module, the LED array comprising one or more LEDs (302, 402, 32) and connected to ground, wherein a voltage across the resistor (R3, 54) is proportional to a current through the one or more LEDs (302, 402, 32); and
a single stage AC input boost converter (306, 406, 500, 600) comprising:
a differential amplifier (U1, 330, 60), wherein a first input of the differential amplifier (U1, 330, 60) is coupled to the voltage across the resistor (R3, 54) and a second input of the differential amplifier (U1, 330, 60) is coupled to a variable dimming voltage (V_{RefDim}, V_{dim}) controlled by a user;
a controller (316, 416, 200) for regulating an output voltage supplied to an anode end of the LED array (304, 404) , wherein the controller (316, 416, 200) comprises an error amplifier having a first input coupled to a fixed internal reference voltage (V_{RefOut}) and a second input coupled to an output of the differential amplifier (U1, 330, 60); and
a switching transistor (318, 418, 46) coupled to the controller (316, 416, 200, 86), wherein the controller (316, 416, 200) turns the switching transistor (318, 418, 46) on and off based on the output of the differential amplifier (U1, 330, 60) to vary the output voltage of the single stage AC input boost converter (306, 406, 500, 600) and the current through the one or more LEDs of the LED array (304, 404) such that the voltage across the resistor (R3, 54) is regulated to the variable dimming voltage (V_{RefDim}, V_{dim}).

2. The LED module according to the preceding claim, wherein the LED array (304, 404) comprises a plurality of single junction LEDs connected in series.

3. The LED module according to claim 1, wherein the LED array (304, 404) comprises a plurality of multi-junction LEDs connected in series.

4. The LED module according to any of the preceding claims, wherein the differential amplifier (U1, 330, 60) amplifies a difference between the voltage from the resistor (R3, 54) and the variable dimming voltage (V_{RefDim}, V_{dim}) and provides the amplified difference as the output.

5. The LED module according to any of the preceding claims, wherein the variable dimming voltage (V_{RefDim}, V_{dim}) is controlled by the user through an input device.

6. The LED module according to any of the preceding claims, wherein the error amplifier amplifies a difference between the output voltage of the differential amplifier (U1, 330, 60) and the fixed internal reference voltage (V_{RefOut}) and provides the amplified difference as an output.

7. The LED module according to any of the preceding claims, further comprising:
an inductor (320, 420) coupled to the switching transistor (318, 418, 46);
a first diode (322, 422) coupled to the inductor (320, 420); and
an output capacitor (324, 424) coupled to the inductor (320, 420) and the LED array (304, 404).

8. The LED module according to the preceding claim, wherein the turning on of the switching transistor (318, 418, 46) by the controller (316, 416, 200) couples the inductor (320, 420) to ground to charge the inductor (320, 420).

9. The LED module according to any of the preceding claims 7 to 8, wherein the turning off of the switching transistor (318, 418, 46) by the controller (316, 416, 200) causes the inductor (320, 420) to forward bias the first diode (322, 422) and charge the output capacitor (324, 424, 50) to supply the output voltage and current to the LED array (304, 404).

10. The LED module according to any of the preceding claims 7 to 9, comprising a diode-coupled path containing a second diode (332, 430, 65) between a mains bridge rectifier (312) and the output capacitor (324, 424, 50).

11. The LED module according to any of the preceding claims, wherein the switching transistor (318, 418, 46) turns on and off at a fixed frequency.

12. A method for operating an LED module according to any of claims 1 to 11, the method comprising the steps of:
receiving, by the resistor (R3, 54), a voltage from the cathode end of the LED array (304, 404) comprising the one or more LEDs (302, 402, 32), wherein the voltage across the resistor (R3, 54)is proportional to the current through the one or more LEDs;
receiving, by the differential amplifier (U1, 330, 60) of the single stage AC input boost converter (306, 406, 500, 600), the voltage across the resistor (R3, 54) at the first input and the variable dimming voltage (V_{RefDim}, V_{dim}) controlled by the user at the second input;
receiving, by the error amplifier of the controller (316, 416, 200) of the single stage AC input boost converter (306, 406, 500, 600), an output voltage of the differential amplifier at the first input and the fixed internal reference voltage (V_{RefOut}) at the second input;
receiving, by the switching transistor (318, 418, 46) of the single stage AC input boost converter (306, 406, 500, 600), an input from the controller (316, 416, 200) that turns the switching transistor (318, 418, 46) on and off based on the output voltage of the differential amplifier (U1, 330, 60) to vary the output voltage and the current through the LEDs of the LED array (304, 404),
such that the voltage across the resistor (R3, 54) is regulated to the variable dimming voltage (V_{RefDim}, V_{dim}).

13. The method according to the preceding claim, wherein the controller (316, 416) regulates the output voltage supplied to the anode end of the LED array (304, 404).

14. The method according to any of the preceding claims 12 or 13, further comprising:
coupling, by the switching transistor (318, 418, 46), an inductor (320, 420) to ground when the controller (316, 416, 200) turns the switching transistor (318, 418, 46) on; and
receiving, by the inductor (320, 420), a voltage from ground to charge the inductor (320, 420).

15. The method according to any of the preceding claims 12 to 13, further comprising:
forward biasing, by the inductor (320, 420), a first diode (322, 422) when the switching transistor (318, 418, 46) is turned off by the controller (316, 416, 200);
charging, by the first diode (322, 422), an output capacitor (324, 424); and
supplying, by the capacitor (324, 424), the output voltage and current to the LED array (304, 404).

## Patentansprüche

1. Ein LED-Modul, bestehend aus:
einen Widerstand (R3, 54), der mit einem Kathodenende einer LED-Array (304, 404) des LED-Moduls verbunden ist, wobei die LED-Array eine oder mehrere LEDs (302, 402, 32) umfasst und mit Masse verbunden ist, wobei eine Spannung über dem Widerstand (R3, 54) proportional zu einem Strom durch die eine oder mehreren LEDs (302, 402, 32) ist; und
einen einstufigen AC-Eingangsaufwärtswandler (306, 406, 500, 600), der Folgendes umfasst:
einen Differenzverstärker (U1, 330, 60), wobei ein erster Eingang des Differenzverstärkers (U1, 330, 60) mit der Spannung an dem Widerstand (R3, 54) gekoppelt ist und ein zweiter Eingang des Differenzverstärkers (U1, 330, 60) mit einer variablen Dimmspannung (V_{RefDim}, V_{dim}) gekoppelt ist, die von einem Benutzer gesteuert wird;
eine Steuerung (316, 416, 200) zum Regeln einer Ausgangsspannung, die einem Anodenende der LED-Array (304, 404) zugeführt wird, wobei die Steuerung (316, 416, 200) einen Fehlerverstärker mit einem ersten Eingang, der mit einer festen internen Referenzspannung (V_{RefOut}) gekoppelt ist, und einem zweiten Eingang, der mit einem Ausgang des Differenzverstärkers (U1, 330, 60) gekoppelt ist, umfasst; und
einen Schalttransistor (318, 418, 46), der mit der Steuerung (316, 416, 200, 86) gekoppelt ist, wobei die Steuerung (316, 416, 200) den Schalttransistor (318, 418, 46) auf der Grundlage des Ausgangs des Differenzverstärkers (U1, 330, 60) den Schalttransistor (318, 418, 46) ein- und ausschaltet, um die Ausgangsspannung des einstufigen AC-Eingangsaufwärtswandlers (306, 406, 500, 600) und den Strom durch die eine oder mehrere LEDs des LED-Arrays (304, 404) so zu variieren, dass die Spannung über dem Widerstand (R3, 54) auf die variable Dimmspannung (V_{RefDim}, V_{dim}) geregelt wird.

2. Das LED-Modul nach dem vorhergehenden Anspruch, wobei das LED-Array (304, 404) eine Vielzahl von in Reihe geschalteten Einzelübergang-LEDs umfasst.

3. LED-Modul nach Anspruch 1, wobei das LED-Array (304, 404) eine Vielzahl von in Reihe geschalteten Mehrfachübergang-LEDs umfasst.

4. Das LED-Modul nach einem der vorhergehenden Ansprüche, wobei der Differenzverstärker (U1, 330, 60) eine Differenz zwischen der Spannung vom Widerstand (R3, 54) und der variablen Dimmspannung (V_{RefDim}, V_{dim}) verstärkt und die verstärkte Differenz als Ausgang bereitstellt.

5. LED-Modul nach einem der vorhergehenden Ansprüche, wobei die variable Dimmspannung (V_{RefDim}, V_{dim}) durch den Benutzer über eine Vorrichtung gesteuert wird.

6. Das LED-Modul nach einem der vorhergehenden Ansprüche, wobei der Fehlerverstärker eine Differenz zwischen der Ausgangsspannung des Differenzverstärkers (U1, 330, 60) und der festen internen Referenzspannung (V_{RefOut}) verstärkt und die verstärkte Differenz als Ausgang bereitstellt.

7. Das LED-Modul nach einem der vorangegangenen Ansprüche, das außerdem Folgendes umfasst:
einen Induktor (320, 420), die mit dem Schalttransistor (318, 418, 46) gekoppelt ist;
eine erste Diode (322, 422), die mit der Spule (320, 420) gekoppelt ist; und
einen Ausgangskondensator (324, 424), der mit dem Induktor (320, 420) und dem LED-Array (304, 404) verbunden ist.

8. LED-Modul nach dem vorhergehenden Anspruch, wobei das Einschalten des Schalttransistors (318, 418, 46) durch die Steuerung (316, 416, 200) den Induktor (320, 420) mit Masse koppelt, um den Induktor (320, 420) zu laden.

9. LED-Modul nach einem der vorhergehenden Ansprüche 7 bis 8, wobei das Ausschalten des Schalttransistors (318, 418, 46) durch die Steuerung (316, 416, 200) den Induktor (320, 420) veranlasst, die erste Diode (322, 422) in Durchlassrichtung vorzuspannen und den Ausgangskondensator (324, 424, 50) zu laden, um die Ausgangsspannung und den Ausgangsstrom an die LED-Array (304, 404) zu liefern.

10. LED-Modul nach einem der vorhergehenden Ansprüche 7 bis 9, mit einem diodengekoppelten Pfad, der eine zweite Diode (332, 430, 65) zwischen einem Netz-Brückengleichrichter (312) und dem Ausgangskondensator (324, 424, 50) enthält.

11. Das LED-Modul nach einem der vorhergehenden Ansprüche, wobei der Schalttransistor (318, 418, 46) mit einer festen Frequenz ein- und ausschaltet.

12. Verfahren zum Betrieb eines LED-Moduls nach einem der Ansprüche 1 bis 11, wobei das Verfahren die folgenden Schritte umfasst:
Empfangen. durch den Widerstand (R3, 54), einer Spannung vom Kathodenende des LED-Arrays (304, 404), das die eine oder mehrere LEDs (302, 402, 32) umfasst, wobei die Spannung am Widerstand (R3, 54) proportional zum Strom durch die eine oder mehrere LEDs ist;
Empfangen, durch den Differenzverstärker (U1, 330, 60) des einstufigen AC-Eingangs-Aufwärtswandlers (306, 406, 500, 600), der Spannung über dem Widerstand (R3, 54) am ersten Eingang und der vom Benutzer gesteuerten variablen Dimmspannung (V_{RefDim}, V_{dim}) am zweiten Eingang;
Empfangen, durch den Fehlerverstärker des Reglers (316, 416, 200) des einstufigen AC-Eingangs-Aufwärtswandlers (306, 406, 500, 600), einer Ausgangsspannung des Differenzverstärkers am ersten Eingang und der festen internen Referenzspannung (V_{RefOut}) am zweiten Eingang;
Empfangen, durch den Schalttransistor (318, 418, 46) des einstufigen AC-Eingangsaufwärtswandlers (306, 406, 500, 600), einer Eingabe von der Steuerung (316, 416, 200), die den Schalttransistor (318, 418, 46) basierend auf der Ausgangsspannung des Differenzverstärkers (U1, 330, 60) ein- und ausschaltet, um die Ausgangsspannung und den Strom durch die LEDs des LED-Arrays (304, 404) zu variieren, so dass die Spannung über dem Widerstand (R3, 54) auf die variable Dimmspannung (V_{RefDim}, V_{dim}) geregelt wird.

13. Verfahren nach dem vorhergehenden Anspruch, wobei die Steuerung (316, 416) die Ausgangsspannung regelt, die dem Anodenende der LED-Array (304, 404) zugeführt wird.

14. Verfahren nach einem der vorangehenden Ansprüche 12 oder 13, ferner umfassend:
Koppeln, durch den Schalttransistor (318, 418, 46), eines Induktors (320, 420) mit Masse wenn die Steuerung (316, 416, 200) den Schalttransistor (318, 418, 46) einschaltet; und
Empfangen, durch den Induktor (320, 420), einer Spannung von Masse um den Induktor (320, 420) zu laden.

15. Verfahren nach einem der vorangehenden Ansprüche 12 bis 13, ferner umfassend
Vorspannen, durch den Induktor (320, 420), einer ersten Diode (322, 422) in Durchlassrichtung, wenn der Schalttransistor (318, 418, 46) durch die Steuerung (316, 416, 200) ausgeschaltet wird;
Laden, durch die erste Diode (322, 422), des Ausgangskondensators (324, 424); und
Zuführen, über den Kondensator (324, 424), der Ausgangsspannung und des Ausgangsstroms an die LED-Array (304, 404).

## Revendications

1. Un module LED comprenant :
une résistance (R3, 54) connectée à une extrémité cathodique d'un réseau de LED (304, 404) du module LED, le réseau de LED comprenant une ou plusieurs LED (302, 402, 32) et connectée à la masse, dans laquelle une tension à travers la résistance (R3, 54) est proportionnelle à un courant à travers une ou plusieurs LED (302, 402, 32); et
un convertisseur élévateur à entrée CA à un étage (306, 406, 500, 600) comprenant:
un amplificateur différentiel (U1, 330, 60), dans lequel une première entrée de l'amplificateur différentiel (U1, 330, 60) est couplée à la tension aux bornes de la résistance (R3, 54) et une deuxième entrée de l'amplificateur différentiel (U1, 330, 60) est couplée à une tension de gradation variable (V_{RefDim}, V_{dim}) contrôlée par un utilisateur;
un contrôleur (316, 416, 200) pour réguler une tension de sortie fournie à l'extrémité anodique du réseau de DEL (304, 404), dans lequel le contrôleur (316, 416, 200) comprend un amplificateur d'erreur ayant une première entrée couplée à une tension de référence interne fixe (V_{RefOut}) et une deuxième entrée couplée à une sortie de l'amplificateur différentiel (U1, 330, 60); et
un transistor de commutation (318, 418, 46) couplé au contrôleur (316, 416, 200, 86), dans lequel le contrôleur (316, 416, 200) active et désactive le transistor de commutation (318, 418, 46) en fonction de la sortie de l'amplificateur différentiel (U1, 330, 60) pour faire varier la tension de sortie du convertisseur élévateur à entrée CA à un étage (306, 406, 500, 600) et le courant à travers une ou plusieurs DEL du réseau de DEL (304, 404) de sorte que la tension à travers la résistance (R3, 54) est régulée à la tension de gradation variable (V_{RefDim}, V_{dim}).

2. Le module LED selon la revendication précédente, dans lequel le réseau de LED (304, 404) comprend une pluralité de LED à jonction unique connectées en série.

3. Le module LED selon la revendication 1, dans lequel le réseau de LED (304, 404) comprend une pluralité de LED multi-jonction connectées en série.

4. Le module LED selon l'une des revendications précédentes, dans lequel l'amplificateur différentiel (U1, 330, 60) amplifie une différence entre la tension de la résistance (R3, 54) et la tension de gradation variable (V_{RefDim}, V_{dim}) et fournit la différence amplifiée en tant que sortie.

5. Le module LED selon l'une des revendications précédentes, dans lequel la tension de gradation variable (V_{RefDim}, V_{dim}) est contrôlée par l'utilisateur au moyen d'un dispositif d'entrée.

6. Le module LED selon l'une des revendications précédentes, dans lequel l'amplificateur d'erreur amplifie une différence entre la tension de sortie de l'amplificateur différentiel (U1, 330, 60) et la tension de référence interne fixe (V_{RefOut}) et fournit la différence amplifiée en tant que sortie.

7. Le module LED selon l'une des revendications précédentes, comprenant en outre:
un inducteur (320, 420) couplé au transistor de commutation (318, 418, 46);
une première diode (322, 422) couplée à l'inducteur (320, 420); et
un condensateur de sortie (324, 424) couplé à l'inducteur (320, 420) et au réseau de DEL (304, 404).

8. Le module LED selon la revendication précédente, dans lequel l'activation du transistor de commutation (318, 418, 46) par le contrôleur (316, 416, 200) couple l'inducteur (320, 420) à la masse pour charger l'inducteur (320, 420).

9. Le module LED selon l'une des revendications précédentes 7 à 8, dans lequel la désactivation du transistor de commutation (318, 418, 46) par le contrôleur (316, 416, 200) amène l'inducteur (320, 420) à polariser vers l'avant la première diode (322, 422) et à charger le condensateur de sortie (324, 424, 50) pour fournir la tension et le courant de sortie au réseau de LED (304, 404).

10. Le module LED selon l'une quelconque des revendications précédentes 7 à 9, comprenant un chemin à couplage de diodes contenant une seconde diode (332, 430, 65) entre un pont redresseur de réseau (312) et le condensateur de sortie (324, 424, 50).

11. Le module LED selon l'une des revendications précédentes, dans lequel le transistor de commutation (318, 418, 46) s'allume et s'éteint à une fréquence fixe.

12. Méthode de fonctionnement d'un module LED selon l'une des revendications 1 à 11, la méthode comprenant les étapes suivantes:
recevoir, par la résistance (R3, 54), une tension provenant de l'extrémité cathodique du réseau de DEL (304, 404) comprenant une ou plusieurs DEL (302, 402, 32), la tension aux bornes de la résistance (R3, 54) étant proportionnelle au courant traversant la ou les DEL;
recevoir, par l'amplificateur différentiel (U1, 330, 60) du convertisseur élévateur à entrée CA à un étage en courant alternatif (306, 406, 500, 600), la tension aux bornes de la résistance (R3, 54) à la première entrée et la tension de gradation variable (V_{RefDim}, V_{dim}) commandée par l'utilisateur à la deuxième entrée;
recevoir, par l'amplificateur d'erreur du contrôleur (316, 416, 200) du convertisseur élévateur à entrée CA à un étage (306, 406, 500, 600), une tension de sortie de l'amplificateur différentiel à la première entrée et la tension de référence interne fixe (V_{RefOut}) à la deuxième entrée;
recevoir, par le transistor de commutation (318, 418, 46) du convertisseur élévateur à entrée CA à un étage (306, 406, 500, 600), une entrée du contrôleur (316, 416, 200) qui active et désactive le transistor de commutation (318, 418, 46) en fonction de la tension de sortie de l'amplificateur différentiel (U1, 330, 60) pour faire varier la tension de sortie et le courant à travers les DEL du réseau de DEL (304, 404), de sorte que la tension à travers la résistance (R3, 54) est régulée à la tension de gradation variable (V_{RefDim}, V_{dim}).

13. Méthode selon la revendication précédente, dans laquelle le contrôleur (316, 416) régule la tension de sortie fournie à l'extrémité anodique du réseau de DEL (304, 404).

14. La méthode selon l'une des revendications précédentes 12 ou 13, comprenant en outre:
coupler, par le transistor de commutation (318, 418, 46), un inducteur (320, 420) à la masse lorsque le contrôleur (316, 416, 200) active le transistor de commutation (318, 418, 46); et
recevoir, par l'inducteur (320, 420), une tension provenant de la masse pour charger l'inducteur (320, 420).

15. La méthode selon l'une des revendications précédentes 12 à 13, comprenant en outre
polariser vers l'avant, par l'inducteur (320, 420), une première diode (322, 422) lorsque le transistor de commutation (318, 418, 46) est désactivé par le contrôleur (316, 416, 200);
charger, par la première diode (322, 422), un condensateur de sortie (324, 424); et
fournir, par l'intermédiaire du condensateur (324, 424), la tension et le courant de sortie au réseau de DEL (304, 404).
